# FASCICULE DE BREVET EUROPEEN

(11) **EP 3 823 013 B1**
(45) Date de publication et mention de la délivrance du brevet: **28.06.2023**
(21) Numéro de dépôt: 20207401.9
(22) Date de dépôt: 13.11.2020
(51) Int. Cl.: H01L 21/683

(54) **PROCÉDÉ DE DÉMONTAGE D'UN EMPILEMENT D'AU MOINS TROIS SUBSTRATS**
VERFAHREN ZUR DEMONTAGE EINES STAPELS VON MINDESTENS DREI SUBSTRATEN
METHOD FOR DISMANTLING A STACK OF AT LEAST THREE SUBSTRATES

(30) Priorité: 14.11.2019 FR 1912687
(43) Date de publication de la demande: 19.05.2021
(73) Titulaire: Commissariat à l'Energie Atomique et aux Energies Alternatives, 75015 Paris (FR)
(72) Inventeur: MONTMEAT, Pierre, 38054 GRENOBLE CEDEX 09 (FR); ENOT, Thierry, 38054 GRENOBLE CEDEX 09 (FR); FOURNEL, Frank, 38054 GRENOBLE CEDEX 09 (FR)
(74) Mandataire: Hautier IP

(56) Documents cités:
- FR-A1- 3 015 110
- US-A1- 2016 358 805

## Description

### DOMAINE TECHNIQUE

La présente invention concerne les techniques de transfert de films minces dans le domaine de la microélectronique. Elle trouve à s'appliquer particulièrement avantageusement dans le domaine des techniques de fabrication de composants microélectroniques.

### ÉTAT DE LA TECHNIQUE

Les transferts de films sont souvent réalisés au moyen de techniques de collage(s), ces dernières permettant d'obtenir un empilement de films. L'un des paramètres qui gouverne la réussite des transferts est l'énergie d'adhérence des différents films de l'empilement. Le document US 2016/358805 A1 décrit le démontage d'un empilement d'au moins trois substrats.

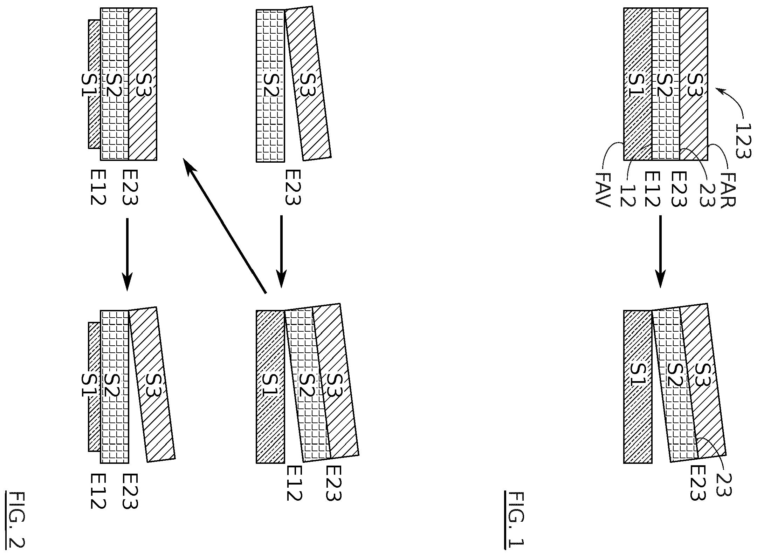

Comme cela est illustré sur la figure 1, un empilement 123 composé de trois films ou substrats, référencés S1, S2 et S3, comporte deux interfaces, référencées 12 et 23, caractérisées respectivement par deux énergies d'adhérence, notées E12 et E23. Si l'énergie d'adhérence E12 est inférieure à l'énergie d'adhérence E23, le démontage de l'empilement 123 conduit naturellement à ouvrir l'interface de plus faible énergie d'adhérence, soit l'interface entre les substrats S1 et S2, plutôt qu'à ouvrir l'interface de plus forte énergie d'adhérence, soit l'interface entre les substrats S2 et S3. Ainsi, si aucune précaution n'est prise pour qu'il en soit autrement, le démontage de l'empilement 123 conduit à séparer l'ensemble S2/S3 du substrat S1 et à libérer ainsi le substrat S1 de l'empilement 123, en supposant que l'énergie de cohésion au sein de chaque film est supérieure au moins à l'énergie d'adhérence E12, voire à l'énergie d'adhérence E23. En revanche, libérer le substrat S3 de l'ensemble S1/S2 n'est pas trivial. Ce constat ressort également du fait qu'un traitement thermique de l'empilement 123, s'il modifierait effectivement les énergies d'adhérence E12 et E23, conserverait à tout le moins la relation d'ordre entre ces énergies d'adhérence.

Il peut cependant être utile, voire nécessaire, de savoir libérer le substrat S3 de l'ensemble S1/S2. On peut rencontrer un tel besoin dans le domaine de la manipulation des plaques fines au moyen du collage temporaire avec des poignées en verre. Un exemple illustratif est décrit ci-dessous en référence à la figure 2.

Sur la figure 2 est illustré un cas où, pour faciliter le traitement et la reconnaissance des films sur certains équipements, on doit pouvoir opacifier le verre de la poignée en y collant une plaque de silicium opaque, puis retirer l'opacification. Plus particulièrement, une poignée en verre S2 peut être opacifiée par une plaque de silicium opaque S3 et être reportée sur un substrat S1 pour en permettre la manipulation. Cette manipulation peut, comme sur l'exemple illustré sur la figure 2, être destinée à permettre un amincissement et un détourage du substrat S1 pour obtenir un film mince, également référencé S1. Le retrait de l'opacification, par exemple afin de pouvoir révéler des marquages sur le film mince S1, implique alors la libération de la plaque de silicium opaque S3 de l'ensemble S1/S2.

Selon un autre exemple, un film de titane et/ou de nitrure de titane peut être utilisé comme opacifiant en étant déposé sur une poignée en verre, avant de devoir en être séparé pour pouvoir mener à bien des étapes technologiques ultérieures.

Actuellement, le retrait de l'opacification est par exemple réalisé par meulage de l'opacifiant, ce qui conduit nécessairement à sa destruction. L'on comprend ainsi qu'il puisse être préférable, notamment lorsque l'opacifiant est une plaque de silicium, de pouvoir le conserver, voire le réutiliser.

Un objet de la présente invention est de proposer un procédé de démontage d'un empilement comprenant au moins trois substrats collés deux à deux par deux interfaces dont l'une présente une énergie d'adhérence supérieure à l'autre, le démontage devant être obtenu par l'interface d'énergie d'adhérence supérieure, de préférence de sorte à conserver l'intégrité des parties de l'empilement démontées l'une de l'autre, de sorte à pouvoir le cas échéant (ré)utiliser l'une et l'autre de ces parties.

Les autres aspects, objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un premier aspect de l'invention, on prévoit un procédé de démontage d'un empilement d'au moins trois substrats présentant entre eux deux interfaces, parmi lesquelles une première interface entre le premier substrat et le deuxième substrat de l'empilement présente une première énergie d'adhérence et une deuxième interface entre le deuxième substrat et le troisième substrat de l'empilement présente une deuxième énergie d'adhérence, la première énergie d'adhérence étant inférieure, voire strictement inférieure, à la deuxième énergie d'adhérence, l'empilement comprenant une face avant et une face arrière entre lesquelles s'étendent successivement le premier substrat, le deuxième substrat, puis le troisième substrat, le procédé de démontage comprenant les étapes successives suivantes :
- Procéder, par la face avant de l'empilement, à un retrait de matière sur le premier substrat, jusqu'à exposer une surface du deuxième substrat,
- Reporter, de préférence par lamination, l'empilement, par sa face avant, sur une couche adhésive d'un film adhésif souple jusqu'à ce que la surface exposée du deuxième substrat soit en contact avec la couche adhésive et présente avec celle-ci une énergie d'adhérence supérieure, de préférence strictement supérieure, à la deuxième énergie d'adhérence, et
- Démonter le troisième substrat du film adhésif souple et de l'ensemble comprenant les premier et deuxième substrats, au niveau de l'interface entre le deuxième substrat et le troisième substrat de l'empilement.

Le procédé de démontage tel qu'introduit ci-dessus permet donc d'ouvrir l'interface présentant, dans l'empilement, une plus forte énergie d'adhérence par rapport à au moins une autre interface de l'empilement. Le procédé répond ainsi à un besoin dans le domaine de la manipulation des plaques fines au moyen d'un collage temporaire, par exemple sur une poignée en verre.

Un autre aspect concerne un dispositif microélectronique à démonter comprenant :
- un empilement d'au moins trois substrats présentant entre eux deux interfaces, parmi lesquelles une première interface entre le premier substrat et le deuxième substrat de l'empilement présente une première énergie d'adhérence et une deuxième interface entre le deuxième substrat et le troisième substrat de l'empilement présente une deuxième énergie d'adhérence, la première énergie d'adhérence étant inférieure, voire strictement inférieure, à la deuxième énergie d'adhérence, l'empilement comprenant une face avant et une face arrière entre lesquelles s'étendent successivement le premier substrat, le deuxième substrat, puis le troisième substrat, le deuxième substrat présentant une surface exposée, et
- un film adhésif souple comprenant une couche adhésive sur laquelle l'empilement est reporté par sa face avant, la surface exposée du deuxième substrat étant en contact avec la couche adhésive et présentant avec celle-ci une énergie d'adhérence supérieure, de préférence strictement supérieure, à la deuxième énergie d'adhérence.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente schématiquement le démontage d'un empilement de trois substrats selon l'art antérieur ;
La figure 2 représente schématiquement un démontage d'un empilement de trois substrats que l'invention vise à permettre ;
Les figures 3A et 3B représentent schématiquement différentes étapes d'un premier mode de réalisation du procédé selon le premier aspect de l'invention ;
La figure 4 représente schématiquement les étapes d'un exemple du premier mode de réalisation du procédé selon le premier aspect de l'invention ;
La figure 5 représente schématiquement différentes étapes d'un deuxième mode de réalisation du procédé selon le premier aspect de l'invention ; et
La figure 6 représente un agrandissement de la partie identifiée par un cercle référencé « détail A » sur la figure 5.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs et les étendues des différents substrats, films et autres couches illustrés ne sont pas nécessairement représentatifs de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Avant l'étape de retrait de matière, les substrats de l'empilement peuvent être sensiblement d'une même étendue et sont de préférence superposés entre eux de façon centrée.
Avant l'étape de retrait de matière, l'empilement peut se présenter sous la forme d'une plaque sensiblement circulaire, par exemple d'environ 300 mm de diamètre.

Le retrait de matière appliqué au premier substrat peut comprendre, voire consister en, un détourage au moins partiel, de préférence total, du premier substrat et le cas échéant un amincissement du premier substrat. Le démontage du troisième substrat est ainsi facilité du fait que la surface exposée comprend au moins une partie de pourtour au niveau de la deuxième interface ; en particulier, un coin peut y être inséré. Plus particulièrement, le détourage du premier substrat peut être effectué en rognant une zone en pourtour du premier substrat sur toute son épaisseur e1, le cas échéant en rognant une zone en pourtour du deuxième substrat sur une profondeur p strictement inférieure à l'épaisseur e2 du deuxième substrat. Par ailleurs, le détourage du premier substrat peut être paramétré de sorte que la surface s'étende sur une première largeur d, prise depuis un bord de la zone en pourtour, supérieure à 0,25 mm.

Selon un premier mode de réalisation du procédé introduit ci-dessus, l'épaisseur de la couche adhésive est choisie supérieure, de préférence strictement supérieure, à l'épaisseur e1 du premier substrat, le cas échéant additionnée de la profondeur p sur laquelle le deuxième substrat a été rogné. Par exemple, l'épaisseur de la couche adhésive est sensiblement égale à 130 µm. Un film adhésif souple selon cette caractéristique permet avantageusement d'encapsuler la topographie de la face avant de l'empilement, du moins sur sa partie s'étendant depuis la surface exposée du deuxième substrat vers la face avant de l'empilement, cette topographie étant au moins due au retrait de matière appliqué au premier substrat par la face avant de l'empilement. Le report de l'empilement sur le film adhésif souple peut alors être effectué de sorte que la surface soit entièrement en contact avec la couche adhésive. Une surface de contact maximale entre le deuxième substrat et la couche adhésive du film adhésif souple est ainsi atteinte, ce qui permet avantageusement de limiter au maximum la largeur d de la zone en pourtour sur laquelle le deuxième substrat doit être exposé.

Selon un deuxième mode de réalisation du procédé introduit ci-dessus, l'épaisseur de la couche adhésive est choisie strictement inférieure, à l'épaisseur e1 du premier substrat, le cas échéant additionnée de la profondeur p sur laquelle le deuxième substrat a été rogné. Par exemple, l'épaisseur de la couche adhésive est sensiblement égale à 10 µm. Le procédé prévoit ainsi une alternative pour le cas où l'épaisseur de la couche adhésive n'est pas suffisante pour encapsuler la topographie de la face avant de l'empilement, rendant le procédé opérationnel avec une large gamme de films adhésifs souples, voir avec tout film adhésif souple. La première largeur d sur laquelle la surface s'étend est alors de préférence supérieure à 1,5 mm. Le procédé permet ainsi de garantir un contact suffisant entre la surface exposée du deuxième substrat et la couche adhésive du film adhésif souple pour que l'énergie d'adhérence entre ladite surface exposée et ladite couche adhésive soit supérieure, voire strictement supérieure, à la deuxième énergie d'adhérence. Par ailleurs, le film adhésif souple présentant une étendue supérieure, de préférence d'un facteur supérieur à 1,25, à l'étendue de l'empilement, le report de l'empilement sur la couche adhésive du film adhésif souple peut comprendre une déformation du film adhésif souple. Le procédé permet ainsi de garantir une capacité suffisante du film adhésif souple à se déformer pour pouvoir contacter adéquatement la surface exposée du deuxième substrat, et éviter ainsi tout risque de rompre le film adhésif souple lors du report de l'empilement. Plus particulièrement, la déformation du film adhésif souple peut être effectuée de sorte que la couche adhésive soit en contact avec une partie au moins de la surface exposée du deuxième substrat, cette partie s'étendant sur une deuxième largeur l, prise depuis un bord du deuxième substrat, supérieure à 0,25 mm. Du fait de l'insuffisance de l'épaisseur de la couche adhésive pour encapsuler la topologie de la face avant de l'empilement, une déformation du film adhésif souple est sollicitée qui, si elle permet une mise en contact suffisante entre la surface exposée de substrat et la couche adhésive du film adhésif souple, ne conduit pas nécessairement à une mise en contact de la totalité de la surface exposée du deuxième substrat avec la couche adhésive du film adhésif souple. Autrement dit, une partie de la surface exposée du deuxième substrat n'est alors généralement pas en contact avec la couche adhésive ; le procédé est pour autant toujours implémentable.

Les caractéristiques énoncées ci-dessous sont relatives indifféremment au premier mode de réalisation et au deuxième mode de réalisation introduits ci-dessus.

La première énergie d'adhérence peut être inférieure à la deuxième énergie d'adhérence d'une valeur comprise entre 0,1 et 1 J/m², de préférence comprise entre 0,2 J/m² et 0,5 J/m². Par exemple, la première énergie d'adhérence est sensiblement égale à 0,4 J/m² et la deuxième énergie d'adhérence est sensiblement égale à 0,7 J/m². En outre, la couche adhésive du film adhésif souple peut présenter initialement, i.e. avant toute réduction de son énergie d'adhérence, le cas échéant par application à la couche adhésive d'un traitement thermique et/ou d'une insolation par UV, une énergie d'adhérence supérieure à la deuxième énergie d'adhérence. Plus particulièrement, l'énergie d'adhérence de la couche adhésive peut être supérieure à 0,7 J/m², de préférence supérieure à 1,0 J/m². L'énergie d'adhérence entre la surface et la couche adhésive peut plus particulièrement être supérieure à la deuxième énergie d'adhérence d'au moins une valeur sensiblement égale à 0,5 J/m². Le procédé permet ainsi de s'assurer de la capacité à ouvrir l'empilement par la deuxième interface en utilisant des méthodes standard pour ce faire.

Deux substrats parmi lesdits au moins trois substrats comprenant chacun un film de scellement à l'autre des deux substrats, l'énergie d'adhérence entre les deux substrats est définie par l'énergie d'adhérence entre les films de scellement. Le procédé permet ainsi de contrôler finement l'énergie d'adhérence entre deux substrats de l'empilement.

La première largeur d sur laquelle la surface exposée du deuxième substrat s'étend est au moins 10 fois, de préférence au moins 100 fois, inférieure à l'étendue du deuxième substrat. En complément ou en alternative, la première largeur d sur laquelle la surface exposée du deuxième substrat s'étend est de préférence inférieure à 10 mm. Le procédé selon chacune de ces deux dernières caractéristiques permet ainsi de limiter la perte de matière induite par l'étape de détourage.

La profondeur p sur laquelle la zone en pourtour du deuxième substrat est le cas échéant retirée est :
- supérieure à 10 µm, par exemple sensiblement égale à 20 µm, et/ou
- strictement inférieure à la moitié, de préférence au dixième, de l'épaisseur du deuxième substrat.

Le procédé permet ainsi de s'assurer :
- d'une part, en limitant le nombre de précautions à prendre, que la couche adhésive du film adhésif souple contacte la surface exposée du deuxième substrat, et non la surface exposée du premier substrat,
- d'autre part de limiter la perte de matière induite par l'étape de détourage.

Le démontage du troisième substrat peut être effectué en insérant un coin dans l'empilement au niveau de la deuxième interface. Le procédé permet ainsi d'assurer le démontage du troisième substrat par une technique standard, ne nécessitant pas de précautions particulières par rapport à l'ordinaire.

Le procédé de démontage selon le premier aspect de l'invention peut en outre comprendre, avant le report de l'empilement sur la couche adhésive du film adhésif souple, au moins une étape technologique appliquée au moins au premier substrat, ladite étape technologique comprenant par exemple au moins une étape choisie parmi : étape de détourage du premier substrat, une étape d'amincissement du premier substrat et une étape de marquage du premier substrat. Le procédé prévoit ainsi avantageusement l'utilisation du troisième substrat comme poignée permettant la manipulation de l'empilement pour conduire l'une au moins des étapes technologiques susmentionnées.

Le procédé de démontage selon le premier aspect de l'invention peut en outre comprendre l'étape suivante : suite au démontage du troisième substrat, libérer l'ensemble comprenant les premier et deuxième substrats depuis le film adhésif souple, le cas échéant en appliquant à la couche adhésive un traitement thermique ou une insolation par UV de sorte à en réduire l'énergie d'adhérence. Le procédé permet ainsi l'utilisation subséquente de l'ensemble comprenant les premier et deuxième substrats, notamment pour la réalisation, sur cet ensemble, d'au moins une étape technologique qui serait complexifiée, voire empêchée, par la présence du troisième substrat et/ou du film adhésif souple.

Par ailleurs, le deuxième substrat peut comprendre, voire être constitué de, une poignée en verre et le troisième substrat peut être à base d'un matériau opaque. De préférence, l'opacité du troisième substrat est une opacité à la lumière visible principalement Le procédé de démontage selon cette caractéristique permet le retrait de l'opacification, ce retrait pouvant être nécessaire pour révéler des marquages sur le premier substrat éventuellement détouré et/ou aminci.

Selon une spécificité, le premier substrat peut comprendre une plaque à base de silicium, ladite plaque présentant par exemple une épaisseur e1 sensiblement égale 775 µm et ayant le cas échéant été détourée en rognant une zone en pourtour de la plaque sur une largeur, prise depuis un bord de la plaque, sensiblement égale à 1,5 mm et sur une profondeur sensiblement égale à 200 µm.

Le procédé de démontage selon cette spécificité peut alors comprendre en outre le dépôt d'un premier film de scellement, sur une surface libre, le cas échéant détourée, de la plaque à base de silicium du premier substrat, pour obtenir le premier substrat. Le premier film de scellement est de préférence à base d'un matériau organique et peut présenter une épaisseur sensiblement égale à 20 µm.

En complément, le troisième substrat peut comprendre, voire est constitué de, une plaque à base de silicium. Cette dernière présente par exemple une épaisseur e3 sensiblement égale 775 µm.

En complément également, le deuxième substrat peut comprendre une plaque de verre. Cette dernière présente par exemple une épaisseur e21 sensiblement égale 700 µm.

Le procédé de démontage selon ces deux derniers compléments peut comprendre en outre le report du troisième substrat sur la plaque de verre constituant le deuxième substrat, de préférence par collage. Par exemple, ce collage est obtenu par recuit à une température sensiblement égale à 250°C pendant une durée sensiblement égale à deux heures.

Le procédé de démontage selon la caractéristique précédente peut comprendre en outre le dépôt d'un deuxième film de scellement sur une surface libre de la plaque de verre, pour obtenir un ensemble comprenant les deuxième et troisième substrats. De préférence, le deuxième film de scellement est à base d'un polymère fluoré et présente une épaisseur sensiblement égale à 5 nm. Le cas échéant, l'ensemble comprenant les deuxième et troisième substrats est obtenu par recuit à une température sensiblement égale à 150°C pendant une durée sensiblement égale à 30 minutes.

En complément, le procédé de démontage selon le premier aspect de l'invention peut comprendre en outre le report du premier substrat sur l'ensemble comprenant les deuxième et troisième substrats, par les premier et deuxième films de scellement. Le procédé de démontage peut alors comprendre en outre une étape consistant à amincir la plaque à base de silicium du premier substrat. De préférence, l'amincissement de la plaque à base de silicium du premier substrat est effectué jusqu'à réduire son épaisseur e1 à une valeur sensiblement comprise entre 50 µm et 100 µm.

Il est précisé que dans le cadre de la présente invention, le terme

On entend par « inférieur » et « supérieur », « inférieur ou égal » et « supérieur ou égal », respectivement. L'égalité est exclue par l'usage des termes « strictement inférieur » et « strictement supérieur ». Egalement, les expressions du type « égal, inférieur, supérieur » s'entendent de comparaisons pouvant accommoder certaines tolérances, notamment selon l'échelle de grandeur des valeurs comparées et les incertitudes de mesure. Des valeurs sensiblement égales, inférieures ou supérieures entrent dans le cadre d'interprétation de l'invention.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

On entend par un film à base d'un matériau A, un film comprenant ce matériau A et éventuellement d'autres matériaux.

Dans la description qui suit, l'épaisseur d'un substrat, d'un film, ou d'une couche, sont généralement mesurées selon des directions perpendiculaires à l'étendue du substrat, du film, ou de la couche. Ainsi, les figures annexées représentant des vues en coupe transversale à l'étendue du substrat, des films ou des couches qui sont représentées, les épaisseurs sont généralement prises selon une direction verticale sur ces figures.

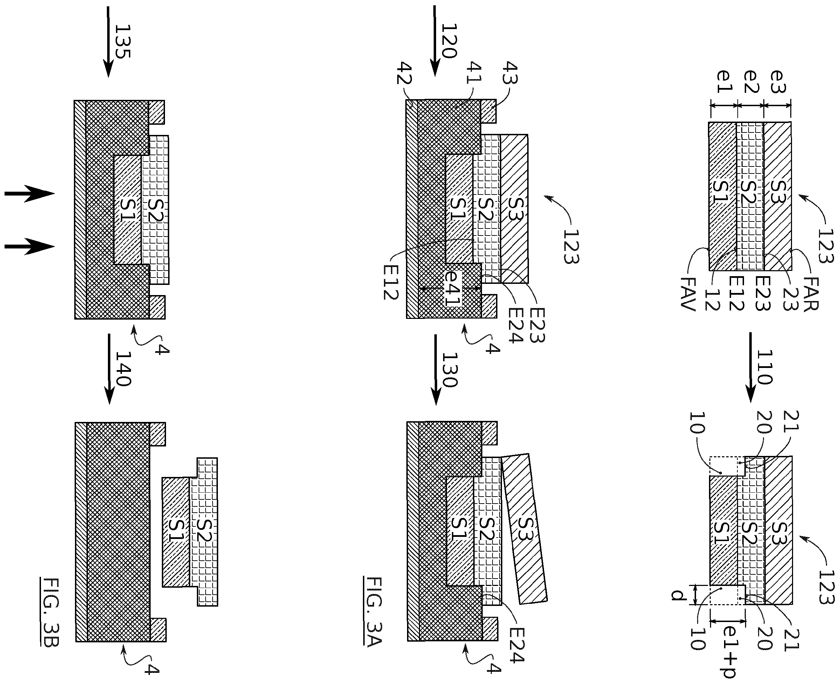

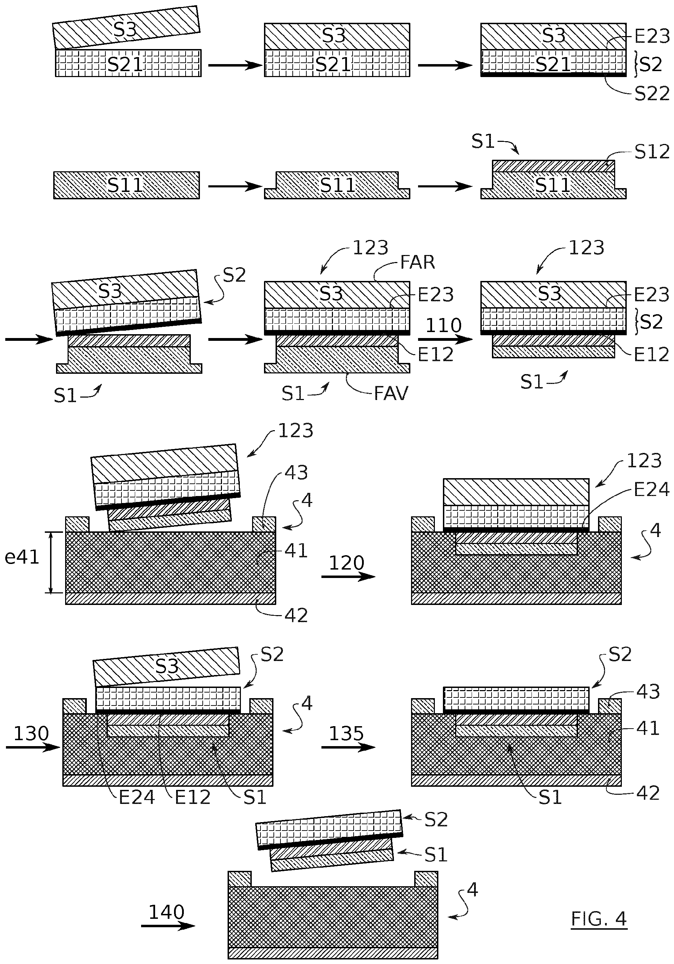

Un premier mode de réalisation du procédé de démontage selon le premier aspect de l'invention est décrit ci-dessous en référence aux figures 3A, 3B et 4.

L'empilement 123 présenté en figure 3A se compose de trois substrats S1, S2, S3 et est caractérisé par des énergies d'adhérence E12 et E23 telles que E12 < E23. L'épaisseur du premier substrat S1 est e1.

On réalise un détourage 110 du substrat S1 sur une largeur d, supérieure à 0,5 mm, de préférence supérieure à 0,25 mm, et une profondeur e1 + p, avec p ≥ 0 µm. Ainsi, le deuxième substrat S2 peut lui-même être détouré 110 d'une profondeur p. On expose ainsi une surface 21 du deuxième substrat S2. Notons que la largeur d est de préférence inférieure à 10 mm.

On vient laminer 120 cet empilement 123 sur un film adhésif souple 4 maintenu par un cadre rigide 43, de façon à réaliser un contact entre la couche adhésive 41 du film 4 et la surface 21 exposée du substrat S2.

Dans le premier mode de réalisation, l'épaisseur e41 de la couche adhésive 41 du film 4 est supérieure à e1+p, de préférence d'au moins 20 µm.

Puis, on vient démonter 130 l'empilement 123 en ouvrant l'interface E23 entre le deuxième substrat S2 et le troisième substrat S3.

Ce démontage 130 est rendu possible du fait que l'interface E12 entre le premier substrat S1 et le deuxième substrat S2 ne peut être ouverte car le substrat S2 est maintenu par l'adhésif de la couche adhésive 41 du film 4. Le substrat S3 est ainsi libéré.

En référence à la figure 3B, le film 4 peut ensuite être insolé sous UV pour libérer l'ensemble S2/S1.

Un exemple complet de mise en oeuvre du premier mode de réalisation du procédé de démontage décrit ci-dessus est présenté en figure 4. On utilise des plaques de 300 mm de diamètre.

On réalise un nettoyage hydrophile (RCA) sur une première plaque de silicium S3 de 775 µm d'épaisseur et sur une plaque de verre S21 de 700 µm d'épaisseur. Les plaques S3 et S21 sont collées puis recuites à 250°C pendant deux heures. On évalue l'énergie d'adhérence E23 du collage par la méthode de Maszara à 0,7 J/m². Sur la plaque de verre S21, on étale un film S22, par exemple un film fluoré de Novec^{™} 2702, et on recuit l'ensemble à 150°C pendant 30 min. On obtient un ensemble S2/S3.

Au moyen d'une scie diamantée, on détoure une seconde plaque de silicium S11 sur une largeur de 1,5 mm et une profondeur de 200 µm. On étale une couche d'adhésif S12, par exemple une couche de 20 µm d'adhésif BrewerBOND^{®} 305, sur cette plaque S11, pour obtenir le premier substrat S1 de l'empilement 123 à former.

On utilise la couche d'adhésif S12 et le film S22 comme films de scellement entre eux. On vient donc coller le premier substrat S1 à 200°C avec l'empilement S3/S2 de façon à créer une interface 12 entre la couche d'adhésif S12 et le film S22. Le collage est réalisé à 200°C. On évalue l'énergie d'adhérence E12 de cette nouvelle interface 12 par la méthode de Maszara à 0,4 J/m².

On amincit par abrasion mécanique au moyen d'une roue diamantée la seconde plaque de silicium S11 à 50 µm. L'empilement 123 aminci est fixé 120 sur un cadre rigide 43 au moyen d'un film souple adhésif 4, par exemple connu sous l'appellation commerciale Furukawa SP-537T-230 qui possède une couche adhésive 41 de 130 µm associée à un film support 42 de 100 µm. La première plaque de silicium S3 est démontée 130 en insérant un coin dans l'empilement 123 au niveau de l'interface 23. Une insolation UV 135 du film souple adhésif 4 permet de libérer 140 l'ensemble formé du premier substrat S1 et du deuxième substrat S2, la seconde plaque de silicium S11 étant amincie.

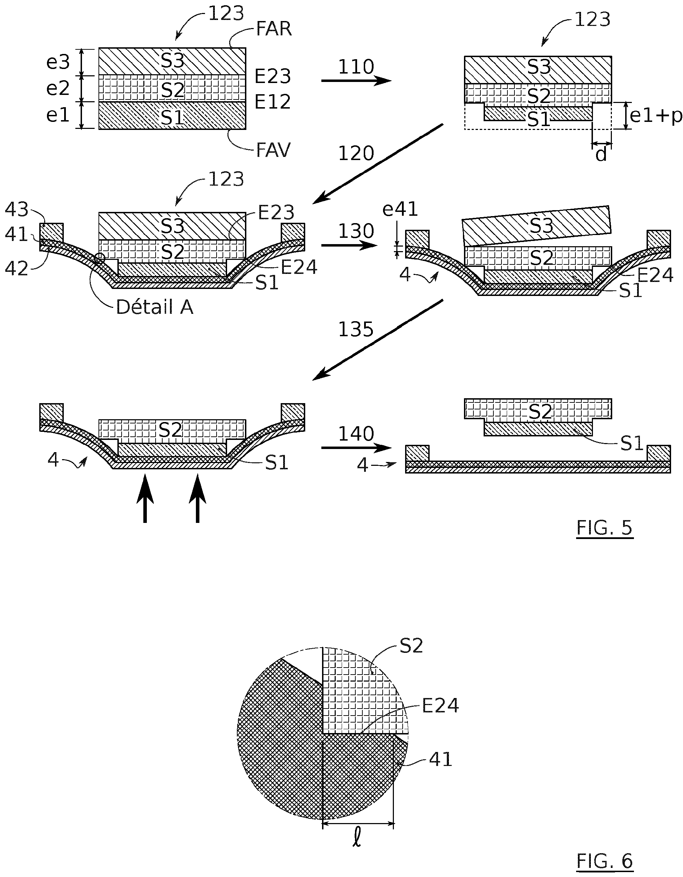

Un deuxième mode de réalisation du procédé de démontage selon le premier aspect de l'invention est décrit ci-dessous en référence aux figures 5 et 6.

Ce deuxième mode de réalisation est à envisager dans le cas où l'épaisseur e41 de la couche adhésive 41 du film souple adhésif 4 n'est pas suffisante pour encapsuler le premier substrat S1 et contacter la surface 21 exposée du deuxième substrat S2 détouré 110.

Un empilement 123, tel qu'illustré sur le figure 5, et potentiellement identique à celui présenté en figure 3A, subit un détourage 110 du premier substrat S1 sur une largeur d, de préférence supérieure à 1,5 mm et sur une profondeur e1 + p, avec p ≥ 0 µm. Ainsi, le substrat S2 peut lui-même être détouré 110 d'une profondeur p.

On vient ensuite laminer 120 cet empilement 123 sur la couche adhésive 41 d'un film adhésif souple 4. Le film 4 est suffisamment souple et le détourage 110 d'une largeur d suffisamment grande pour assurer un contact entre la couche adhésive 41 et la surface 21 exposée du deuxième substrat S2.

Plus particulièrement, comme l'illustre la figure 6, le contact entre la couche adhésive 41 et la surface 21 exposée du deuxième substrat S2 s'étend sur une couronne de largeur l supérieure à 0,25 mm.

On vient démonter 130 la structure en ouvrant l'interface 23 ; l'interface 12 ne peut être ouverte car le deuxième substrat S2 est maintenu par la couche adhésive 41 du film 4. Le troisième substrat S3 est ainsi libéré.

Le film 4 peut alors être insolé sous UV pour libérer l'ensemble S2/S1.

Un exemple complet de mise en oeuvre du deuxième mode de réalisation du procédé de démontage décrit ci-dessus est décrit ci-dessous. On utilise là encore des plaques de 300 mm de diamètre.

On réalise un nettoyage hydrophile (RCA) sur une première plaque de silicium de 775 µm d'épaisseur et sur une plaque de verre de 700 µm d'épaisseur. Les plaques sont collées entre elles, puis recuites à 250°C pendant deux heures. On évalue l'énergie d'adhérence du collage à 0,7 J/m². Sur la plaque de verre du collage, on étale un film fluoré de Novec^{™} 2702 et on recuit l'ensemble à 150°C pendant 30 min.

On étale 20 µm d'adhésif BrewerBOND^{®} 305 sur une seconde plaque de silicium et on vient coller cet ensemble à 200°C avec l'empilement comprenant la première plaque de silicium et la plaque de verre, de façon à créer une interface 12 entre le film d'adhésif BrewerBOND^{®} 305 et le film fluoré Novec^{™} 2702. Le collage est réalisé à 200°C. On évalue l'énergie d'adhérence de cette nouvelle interface 12 à 0,4 J/m².

On amincit ensuite, par abrasion mécanique au moyen d'une roue diamantée, la seconde plaque de silicium à 30 µm.

Au moyen d'une scie diamantée, on effectue un détourage de la seconde plaque de silicium sur une largeur de 2 mm et une profondeur de 50 µm.

L'empilement aminci est fixé sur un cadre rigide au moyen d'un film adhésif souple, par exemple connu sous l'appellation commerciale ADWILL D650, qui possède une couche adhésive de 10 µm d'épaisseur, associée à un film support 42 de 80 µm d'épaisseur. La première plaque de silicium est démontée en insérant un coin dans l'empilement.

Une insolation UV du film adhésif permet de libérer la seconde plaque de silicium amincie.

Un autre aspect concerne le produit intermédiaire comprenant :
- l'empilement 123 des trois substrats S1, S2, S3, le deuxième substrat S2 présentant une surface 21 exposée, et
- le film adhésif souple 4 reporté sur la face avant FAV de l'empilement 123.

Un tel dispositif micro-électronique est par exemple représenté sur la figure 3A en bas à gauche, sur la figure 4 en quatrième ligne à droite, et sur la figure 5 en deuxième ligne à gauche.

L'invention n'est pas limitée aux modes de réalisations précédemment décrits et s'étend à tous les modes de réalisation couverts par les revendications.

Par exemple, le retrait de matière 110 peut être réalisé par différentes autres méthodes de la micro-électronique que par un procédé mécanique, et notamment un rognage. Il peut plus particulièrement s'agir d'une gravure sèche ou humide, par exemple au moyen d'une étape de photolithographie.

Par exemple, la réduction de l'énergie d'adhérence du film adhésif souple 4 peut être obtenue par traitement thermique.

L'utilisation d'un coin pour démonter 130 l'empilement 123 n'est pas incontournable. Des alternatives existent qui font partie de techniques de démontage connues. Un traitement thermique peut par exemple suffire. On peut encore utiliser un anneau configuré pour mettre en prise le troisième substrat S3 ou une ventouse.

D'autres choix de films adhésifs souples 4 que les exemples donnés ci-dessus sont envisageables. Un tel choix peut dépendre, entre autres, de la technique de nettoyage des premier et deuxième substrats S1 et S2 envisagée suite à leur libération depuis le film adhésif souple 4.

Le retrait de matière 110 appliqué au premier substrat S1, voire à une partie du second substrat S2, peut ne pas consister en un détourage complet, mais peut comprendre un détourage partiel, par exemple en quart de cercle, en demi-cercle, ou en croissant de lune. Le retrait de matière 110 peut encore comprendre, voire consister en, une gravure d'une partie du premier substrat ne comprenant pas un de ses bords.

## Revendications

1. Procédé de démontage d'un empilement (123) d'au moins trois substrats (S1, S2, S3) présentant entre eux deux interfaces (12, 23), parmi lesquelles une première interface (12) entre le premier substrat (S1) et le deuxième substrat (S2) de l'empilement (123) présente une première énergie d'adhérence (E12) et une deuxième interface (23) entre le deuxième substrat (S2) et le troisième substrat (S3) de l'empilement (123) présente une deuxième énergie d'adhérence (E23), la première énergie d'adhérence (E12) étant inférieure, voire strictement inférieure, à la deuxième énergie d'adhérence (E23), l'empilement comprenant une face avant (FAV) et une face arrière (FAR) entre lesquelles s'étendent successivement le premier substrat (S1), le deuxième substrat (S2), puis le troisième substrat (S3), le procédé de démontage comprenant les étapes successives suivantes :
- Procéder, par la face avant (FAV) de l'empilement (123), à un retrait de matière (110) sur le premier substrat (S1), jusqu'à exposer une surface (21) du deuxième substrat (S2),
- Reporter (120) l'empilement (123), par sa face avant (FAV), sur une couche adhésive (41) d'un film adhésif souple (4) jusqu'à ce que la surface exposée (21) du deuxième substrat (S2) soit en contact avec la couche adhésive (41) et présente avec celle-ci une énergie d'adhérence (E24) supérieure, de préférence strictement supérieure, à la deuxième énergie d'adhérence (E23), et
- Démonter (130) le troisième substrat (S3) du film adhésif souple (4) et de l'ensemble comprenant les premier et deuxième substrats (S1, S2), au niveau de l'interface (23) entre le deuxième substrat (S2) et le troisième substrat (S3) de l'empilement (123).

2. Procédé de démontage selon la revendication 1, dans lequel le retrait de matière (110) appliqué au premier substrat (S1) comprend, voire consiste en, un détourage au moins partiel du premier substrat (S1) et le cas échéant un amincissement du premier substrat (S1).

3. Procédé de démontage selon la revendication précédente, dans lequel le détourage du premier substrat (S1) est effectué en rognant une zone en pourtour (10) du premier substrat (S1) sur toute son épaisseur e1, le cas échéant en rognant une zone en pourtour (20) du deuxième substrat (S2) sur une profondeur p strictement inférieure à l'épaisseur e2 du deuxième substrat (S2).

4. Procédé de démontage selon l'une quelconque des deux revendications précédentes, dans lequel le détourage du premier substrat (S1) est paramétré de sorte que la surface (21) s'étende sur une première largeur d, prise depuis un bord de la zone en pourtour (10), supérieure à 0,25 mm.

5. Procédé de démontage selon l'une quelconque des revendications précédentes, dans lequel l'épaisseur e41 de la couche adhésive (41) est choisie supérieure, de préférence strictement supérieure, à l'épaisseur e1 du premier substrat (S1).

6. Procédé de démontage selon les revendications 1 et 2 et l'une quelconque des revendications 3 et 4, dans lequel l'épaisseur e41 de la couche adhésive (41) est choisie strictement inférieure, à l'épaisseur e1 du premier substrat (S1).

7. Procédé de démontage selon la revendication précédente en combinaison avec la revendication 4, dans lequel la première largeur d sur laquelle la surface (21) s'étend est supérieure à 1,5 mm.

8. Procédé de démontage selon l'une quelconque des revendications précédentes, dans lequel la première énergie d'adhérence (E12) est inférieure à la deuxième énergie d'adhérence (E23) d'une valeur comprise entre 0,1 et 1 mJ/m², de préférence comprise entre 0,2 mJ/m² et 0,5 mJ/m², et dans lequel la couche adhésive (41) du film adhésif souple (4) présente initialement une énergie d'adhérence supérieure à la deuxième énergie d'adhérence (E23).

9. Procédé de démontage selon l'une quelconque des revendications précédentes, dans lequel l'énergie d'adhérence (E24) entre la surface (21) et la couche adhésive (41) est supérieure à la deuxième énergie d'adhérence (E23) d'au moins une valeur sensiblement égale à 500 mJ/m².

10. Procédé de démontage selon l'une quelconque des revendications précédentes, dans lequel, deux substrats parmi lesdits au moins trois substrats (S1, S2, S3) comprenant chacun un film de scellement à l'autre des deux substrats, l'énergie d'adhérence entre les deux substrats est définie par l'énergie d'adhérence entre les films de scellement.

11. Procédé de démontage selon l'une quelconque des revendications 3 à 10, dans lequel la profondeur p sur laquelle la zone en pourtour (20) du deuxième substrat (S2) est le cas échéant rognée est :
a. supérieure à 10 µm, par exemple sensiblement égale à 20 µm, et/ou
b. strictement inférieure à la moitié, de préférence au dixième, de l'épaisseur e2 du deuxième substrat (S2).

12. Procédé de démontage selon l'une quelconque des revendications précédentes comprenant en outre, avant le report (120) de l'empilement (123) sur la couche adhésive (41) du film adhésif souple (4), au moins une étape technologique appliquée au moins au premier substrat (S1), ladite étape technologique comprenant par exemple au moins une étape choisie parmi : étape de détourage du premier substrat (S1), une étape d'amincissement du premier substrat (S1) et une étape de marquage du premier substrat (S1).

13. Procédé de démontage selon l'une quelconque des revendications précédentes comprenant en outre l'étape suivante :
- suite au démontage (130) du troisième substrat (S3), libérer (140) l'ensemble comprenant les premier et deuxième substrats (S1, S2) depuis le film adhésif souple (4), le cas échéant en appliquant (135) à la couche adhésive (41) un traitement thermique ou une insolation par UV de sorte à en réduire l'énergie d'adhérence.

14. Procédé de démontage selon l'une quelconque des revendications précédentes, dans lequel le deuxième substrat (S2) comprend, voire est constitué de, une poignée en verre et le troisième substrat (S3) est à base d'un matériau opaque.

15. Dispositif microélectronique à démonter comprenant :
- un empilement (123) d'au moins trois substrats (S1, S2, S3) présentant entre eux deux interfaces (12, 23), parmi lesquelles une première interface (12) entre le premier substrat (S1) et le deuxième substrat (S2) de l'empilement (123) présente une première énergie d'adhérence (E12) et une deuxième interface (23) entre le deuxième substrat (S2) et le troisième substrat (S3) de l'empilement (123) présente une deuxième énergie d'adhérence (E23), la première énergie d'adhérence (E12) étant inférieure, voire strictement inférieure, à la deuxième énergie d'adhérence (E23), l'empilement comprenant une face avant (FAV) et une face arrière (FAR) entre lesquelles s'étendent successivement le premier substrat (S1), le deuxième substrat (S2), puis le troisième substrat (S3), le deuxième substrat (S2) présentant une surface (21) exposée, et
- un film adhésif souple (4) comprenant une couche adhésive (41) sur laquelle l'empilement (123) est reporté par sa face avant (FAV), la surface exposée (21) du deuxième substrat (S2) étant en contact avec la couche adhésive (41) et présentant avec celle-ci une énergie d'adhérence (E24) supérieure, de préférence strictement supérieure, à la deuxième énergie d'adhérence (E23).

## Patentansprüche

1. Verfahren zum Zerlegen eines Stapels (123) von mindestens drei Substraten (S1, S2, S3), die zwischen sich zwei Grenzflächen (12, 23) aufweisen, wobei eine erste Grenzfläche (12) zwischen dem ersten Substrat (S1) und dem zweiten Substrat (S2) des Stapels (123) eine erste Adhäsionsenergie (E12) aufweist, und eine zweite Grenzfläche (23) zwischen dem zweiten Substrat (S2) und dem dritten Substrat (S3) des Stapels (123) eine zweite Adhäsionsenergie (E23) aufweist, wobei die erste Adhäsionsenergie (E12) niedriger oder sogar streng niedriger als die zweite Adhäsionsenergie (E23) ist, wobei der Stapel eine Vorderseite (FAV) und eine Rückseite (FAR) umfasst, zwischen denen sich aufeinanderfolgend das erste Substrat (S1), das zweite Substrat (S2) und anschließend das dritte Substrat (S3) erstrecken, wobei das Zerlegungsverfahren die folgenden aufeinanderfolgenden Schritte umfasst:
- Vornehmen, über die Vorderseite (FAV) des Stapels (123), einer Materialschwindung (110) auf dem ersten Substrat (S1), bis eine Oberfläche (21) des zweiten Substrats (S2) freigelegt wird,
- Übertragen (120) des Stapels (123), mit seiner Vorderseite (FAV), auf eine Klebeschicht (41) einer flexiblen Klebefolie (4), bis die freigelegte Oberfläche (21) des zweiten Substrats (S2) mit der Klebeschicht (41) in Kontakt steht, und mit dieser eine höhere Adhäsionsenergie (E24) aufweist, vorzugsweise streng höhere, als die zweite Adhäsionsenergie (E23), und
- Zerlegen (130) des dritten Substrats (S3) der flexiblen Klebefolie (4) und der Anordnung, die das erste und zweite Substrat (S1, S2) umfasst, im Bereich der Grenzfläche (23) zwischen dem zweiten Substrat (S2) und dem dritten Substrat (S3) des Stapels (123).

2. Zerlegungsverfahren nach Anspruch 1, wobei die Materialschwindung (110), die auf das erste Substrat (S1) angewandt wird, umfasst oder sogar besteht aus einer mindestens teilweisen Freistellung des ersten Substrats (S1) und gegebenenfalls einer Ausdünnung des ersten Substrats (S1).

3. Zerlegungsverfahren nach dem vorhergehenden Anspruch, wobei die Freistellung des ersten Substrats (S1) durch Beschneiden einer Umrandungszone (10) des ersten Substrats (S1) über seine gesamte Dicke e1 vorgenommen wird, gegebenenfalls durch Freistellung einer Umrandungszone (20) des zweiten Substrats (S2) bis zu einer Tiefe p, die streng kleiner ist als die Dicke e2 des zweiten Substrats (S2).

4. Zerlegungsverfahren nach einem der zwei vorhergehenden Ansprüche, wobei die Freistellung des ersten Substrats (S1) so eingestellt ist, dass sich die Oberfläche (21) über eine erste Breite d erstreckt, die von einem Rand der Umrandungszone (10) abgenommen wird, größer als 0,25 mm.

5. Zerlegungsverfahren nach einem der vorhergehenden Ansprüche, wobei die Dicke e41 der Klebeschicht (41) größer, vorzugsweise streng größer, als die Dicke e1 des ersten Substrats (S1) gewählt wird.

6. Zerlegungsverfahren nach den Ansprüchen 1 und 2 und einem der Ansprüche 3 und 4, wobei die Dicke e41 der Klebeschicht (41) streng kleiner als die Dicke e1 des ersten Substrats (S1) gewählt wird.

7. Zerlegungsverfahren nach dem vorhergehenden Anspruch in Kombination mit Anspruch 4, wobei die erste Breite d, auf der sich die Oberfläche (21) erstreckt, größer als 1,5 mm ist.

8. Zerlegungsverfahren nach einem der vorhergehenden Ansprüche, wobei die erste Adhäsionsenergie (E12) niedriger ist als die zweite Adhäsionsenergie (E23), um einen Wert zwischen 0,1 und 1 mJ/m², vorzugsweise zwischen 0,2 mJ/m² und 0,5 mJ/m², und wobei die Klebeschicht (41) der flexiblen Klebefolie (4) anfänglich eine Adhäsionsenergie aufweist, die höher ist als die zweite Adhäsionsenergie (E23).

9. Zerlegungsverfahren nach einem der vorhergehenden Ansprüche, wobei die Adhäsionsenergie (E24) zwischen der Oberfläche (21) und der Klebeschicht (41) höher ist als die zweite Adhäsionsenergie (E23), um mindestens einen Wert von im Wesentlichen 500 mJ/m².

10. Zerlegungsverfahren nach einem der vorhergehenden Ansprüche, wobei zwei Substrate von den mindestens drei Substraten (S1, S2, S3) jeweils eine Versiegelungsfolie zum anderen der zwei Substrate umfassen, wobei die Adhäsionsenergie zwischen den zwei Substraten durch die Adhäsionsenergie zwischen den Versiegelungsfolien definiert ist.

11. Zerlegungsverfahren nach einem der Ansprüche 3 bis 10, wobei die Tiefe p, auf die die Umrandungszone (20) des zweiten Substrats (S2) gegebenenfalls beschnitten wird, ist:
a. größer als 10 µm, beispielsweise im Wesentlichen gleich 20 µm, und/oder
b. streng kleiner als die Hälfte, vorzugsweise ein Zehntel, der Dicke e2 des zweiten Substrats (S2).

12. Zerlegungsverfahren nach einem der vorhergehenden Ansprüche, ferner umfassend, vor dem Übertragen (120) des Stapels (123) auf die Klebeschicht (41) der flexiblen Klebefolie (4), mindestens einen technologischen Schritt, der mindestens auf das erste Substrat (S1) angewandt wird, wobei der technologische Schritt beispielsweise mindestens einen Schritt umfasst, der ausgewählt wird aus: einem Schritt der Freistellung des ersten Substrats (S1), einem Schritt der Ausdünnung des ersten Substrats (S1) und einem Schritt der Markierung des ersten Substrats (S1).

13. Zerlegungsverfahren nach einem der vorhergehenden Ansprüche, ferner den folgenden Schritt umfassend:
- nach der Zerlegung (130) des dritten Substrats (S3), Lösen (140) der Anordnung, die das erste und zweite Substrat (S1, S2) umfasst, von der flexiblen Klebefolie (4), gegebenenfalls durch Anwenden (135) an der Klebeschicht (41) einer Wärmebehandlung oder UV-Bestrahlung, um deren Adhäsionsenergie zu verringern.

14. Zerlegungsverfahren nach einem der vorhergehenden Ansprüche, wobei das zweite Substrat (S2) einen Glasgriff umfasst oder sogar aus diesem besteht und das dritte Substrat (S3) auf einem opaken Material basiert.

15. Mikroelektronische Vorrichtung, die zu zerlegen ist, umfassend:
- einen Stapel (123) von mindestens drei Substraten (S1, S2, S3), die zwischen sich zwei Grenzflächen (12, 23) aufweisen, wobei eine erste Grenzfläche (12) zwischen dem ersten Substrat (S1) und dem zweiten Substrat (S2) des Stapels (123) eine erste Adhäsionsenergie (E12) aufweist, und eine zweite Grenzfläche (23) zwischen dem zweiten Substrat (S2) und dem dritten Substrat (S3) des Stapels (123) eine zweite Adhäsionsenergie (E23) aufweist, wobei die erste Adhäsionsenergie (E12) niedriger oder sogar streng niedriger als die zweite Adhäsionsenergie (E23) ist, wobei der Stapel eine Vorderseite (FAV) und einer Rückseite (FAR) umfasst, zwischen denen sich aufeinanderfolgend das erste Substrat (S1), das zweite Substrat (S2) und anschließend das dritte Substrat (S3) erstrecken, wobei das zweite Substrat (S2) eine freigelegte Oberfläche (21) aufweist, und
- eine flexible Klebefolie (4), die eine Klebeschicht (41) umfasst, auf die der Stapel (123) mit ihrer Vorderseite (FAV) übertragen ist, wobei die freigelegte Oberfläche (21) des zweiten Substrats (S2) mit der Klebeschicht (41) in Kontakt steht und mit dieser eine höhere Adhäsionsenergie (E24) aufweist, vorzugsweise streng höhere, als die zweite Adhäsionsenergie (E23).

## Claims

1. Method for disassembling a stack (123) of at least three substrates (S1, S2, S3) having between them two interfaces (12, 23), among which a first interface (12) between the first substrate (S1) and the second substrate (S2) of the stack (123) has a first adhesion energy (E12) and a second interface (23) between the second substrate (S2) and the third substrate (S3) in the stack (123) has a second adhesion energy (E23), the first adhesion energy (E12) being lower, or even strictly lower, than the second adhesion energy (E23), the stack comprising a front face (FAV) and a rear face (FAR) between which the first substrate (S1), the second substrate (S2) and then the third substrate (S3) extend successively, the disassembly method comprising the following successive steps:
- implementing, through the front face (FAV) of the stack (123), a removal of material (110) on the first substrate (S1), until a surface (21) of the second substrate (S2) is exposed,
- transferring (120) the stack (123), by means of the front face (FAV) thereof, onto an adhesive layer (41) of a flexible adhesive film (4) until the exposed surface (21) of the second substrate (S2) is in contact with the adhesive layer (41) and has therewith an adhesion energy (E24) that is greater, preferably strictly greater, than the second adhesion energy (E23), and
- disassembling (130) the third substrate (S3) from the flexible adhesive film (4) and from the assembly comprising the first and second substrates (S1, S2), at the interface (23) between the second substrate (S2) and the third substrate (S3) in the stack (123).

2. Disassembly method according to claim 1, wherein the removal of material (110) applied to the first substrate (S1) comprises, or even consists of, an at least partial trimming of the first substrate (S1) and where applicable a thinning of the first substrate (S1).

3. Disassembly method according to the preceding claim, wherein the trimming of the first substrate (S1) is implemented by cropping a peripheral region (10) of the first substrate (S1) over the entire thickness e1 thereof, where applicable by cropping a peripheral region (20) of the second substrate (S2) over a depth p strictly less than the thickness e2 of the second substrate (S2).

4. Disassembly method according to either one of the preceding two claims, wherein the trimming of the first substrate (S1) is parameterised so that the surface (21) extends over a first width d, taken from one edge of the peripheral region (10), greater than 0.25 mm.

5. Disassembly method according to any one of the preceding claims, wherein the thickness e41 of the adhesive layer (41) is selected greater than, preferably strictly greater than, the thickness e1 of the first substrate (S1).

6. Disassembly method according to claims 1 and 2 and either one of claims 3 and 4, wherein the thickness e41 of the adhesive layer (41) is selected strictly less than the thickness e1 of the first substrate (S1).

7. Disassembly method according to the preceding claim in combination with claim 4, wherein the first width d over which the surface (21) extends is greater than 1.5 mm.

8. Disassembly method according to any one of the preceding claims, wherein the first adhesion energy (E12) is less than the second adhesion energy (E23) by a value of between 0.1 and 1 mJ/m², preferably between 0.2 mJ/m² and 0.5 mJ/m² and wherein the adhesive layer (41) of the flexible adhesive film (4) initially has an adhesion energy greater than the second adhesion energy (E23).

9. Disassembly method according to any one of the preceding claims, wherein the adhesion energy (E24) between the surface (21) and the adhesive layer (41) is greater than the second adhesion energy (E23) by at least a value substantially equal to 500 mJ/m².

10. Disassembly method according to any one of the preceding claims, wherein, two substrates from said at least three substrates (S1, S2, S3) each comprising a film for anchoring to the other of the two substrates, the adhesion energy between the two substrates is defined by the adhesion energy between the anchoring films.

11. Disassembly method according to any one of claims 3 to 10, wherein the depth p over which the peripheral region (20) of the second substrate (S2) is where applicable cropped is:
a. greater than 10 µm, for example substantially equal to 20 µm, and/or
b. strictly less than half, preferably less than one tenth, of the thickness e2 of the second substrate (S2).

12. Disassembly method according to any one of the preceding claims, further comprising, before the stack (123) is transferred (120) onto the adhesive layer (41) of the flexible adhesive film (4), at least one technological step applied at least to the first substrate (S1), said technological step comprising for example at least one step selected from: step of trimming the first substrate (S1), a step of thinning the first substrate (S1) and a step of marking the first substrate (S1).

13. Disassembly method according to any one of the preceding claims, further comprising the following step:
- following the disassembling (130) of the third substrate (S3), releasing (140) the assembly comprising the first and second substrates (S1, S2) from the flexible adhesive film (4), where applicable by applying (135) to the adhesive layer (41) a heat treatment or an insolation by UV so as to reduce the adhesion energy thereof.

14. Disassembly method according to any one of the preceding claims, wherein the second substrate (S2) comprises, or even consists of, a glass handle and the third substrate (S3) is based on an opaque material.

15. Microelectronic device to be disassembled, comprising:
- a stack (123) of at least three substrates (S1, S2, S3) having between them two interfaces (12, 23), among which a first interface (12) between the first substrate (S1) and the second substrate (S2) of the stack (123) has a first adhesion energy (E12) and a second interface (23) between the second substrate (S2) and the third substrate (S3) in the stack (123) has a second adhesion energy (E23), the first adhesion energy (E12) being lower, or even strictly lower, than the second adhesion energy (E23), the stack comprising a front face (FAV) and a rear face (FAR) between which the first substrate (S1), the second substrate (S2) and then the third substrate (S3) extend successively, the second substrate (S2) having an exposed surface (21), and
- a flexible adhesive film (4) comprising an adhesive layer (41) onto which the stack (123) is transferred by means of the front face (FAV) thereof, the exposed surface (21) of the second substrate (S2) being in contact with the adhesive layer (41) and having therewith an adhesion energy (E24) greater, preferably strictly greater, than the second adhesion energy (E23).
